Europäisches Patentamt

(19) European Patent Office

Office européen des brevets

(11) Publication number: **0 052 226**
**B1**

(12) # EUROPEAN PATENT SPECIFICATION

(45) Date of publication of patent specification: **16.04.86**     (51) Int. Cl.⁴: **H 03 M 1/66**

(21) Application number: **81108090.2**

(22) Date of filing: **08.10.81**

(54) **Digital to analog converting apparatus.**

(30) Priority: **13.11.80 JP 159929/80**

(43) Date of publication of application:
**26.05.82 Bulletin 82/21**

(45) Publication of the grant of the patent:
**16.04.86 Bulletin 86/16**

(84) Designated Contracting States:
**DE FR GB**

(56) References cited:
**FR-A-1 359 346**
**US-A-2 855 540**

(73) Proprietor: **Kabushiki Kaisha Toshiba**
**72, Horikawa-cho Saiwai-ku**
**Kawasaki-shi Kanagawa-ken 210 (JP)**

(72) Inventor: **Ono, Masahiko**
**4-14-3-3 Kamiyoga**
**Setagaya-ku Tokyo (JP)**

(74) Representative: **Henkel, Feiler, Hänzel & Partner**
**Möhlstrasse 37**
**D-8000 München 80 (DE)**

Courier Press, Leamington Spa, England.

## Description

This invention relates to a digital to analog converting apparatus comprising digital to analog converting means having first and second input terminals and generating an analog signal corresponding to a digital signal supplied to the first input terminal and an analog to digital converting means connected to the digital to analog converting means and supplying the second input terminal with a digital signal corresponding to the analog signal generated by the digital to analog converting means, the digital to analog converting means comprising operation means having the first and second input terminals and generating comparison signals representing a difference between two signals supplied to the first and second input terminals, the first input terminal being connected to receive a digital signal, current generating means connected to the operation means for generating current according to the value of the comparison signal, and a capacitor connected to the current generating means, said analog to digital converting means being connected to said capacitor and the second input terminal of said operation means and converting the output voltage of said capacitor to a digital signal.

There has long been used a digital to analog (D/A) converting apparatus having a plurality of switches, a resistor ladder circuit, an A/D converter, a comparator and a switching control circuit. The switches are opened and closed under the control of the switching control circuit, whereby the resistor ladder circuit divides a power source voltage and generates an analog voltage of a desired value. The analog voltage is applied to the comparator through the A/D converter and is then compared with a digital input signal supplied to the comparator. The output of the comparator is supplied to the switching control circuit. According to the output of the comparator the switching control circuit controls the switches. This sequence of operation is repeated until the two input signals of the comparator come to have the same value. When the input signals of the comparator become the same, that is, when the output voltage of the resistor ladder circuit comes to have the same value as that of the digital input signal, the D/A conversion is completed.

The above-mentioned D/A converting apparatus responds very quickly indeed. Provided with a resistor ladder circuit, however, it needs a large circuitry and is inevitably expensive.

Document US—A—2 855 540 discloses an apparatus comprising a subtractor having first and second input terminals for generating output signals representing a difference between two signals supplied to the first and second input terminal, said first input terminal being connected to an input register and said second input terminal being connected to receive a digital signal which is converted from an analog signal. The apparatus further comprises current generating means for generating current according to the value of the aforementioned output signal and a capacitor connected to the output of the current generating means. The output of the current generating means and the capacitor are connected to an amplifier the output of which being connected to converter means for supplying a digital signal to said second terminals. The subtractor supplies for each pair of digits to be compared as output signal the sign of which controls the direction of current flow through the corresponding current generator, and the value of which is utilized to start and stop the corresponding current generator, whereby each generator supplies a signal having a weight proportional to the numerical weight of the corresponding pair of digits. However, this prior art document does not disclose a D/A converting apparatus but enables a beam positioning system which is independent of voltage variations due to instability and aging of the active components.

It is an object of this invention to provide a digital to analog converting apparatus which has a small circuitry and which is thus inexpensive.

To achieve this object the invention provides a digital to analog converting means as defined above and which is characterized in that said operation means generates two digital comparison signals, in that the current generating means is connected to a power source and has a first current source, a first switching element connected to the first current source, a second switching element connected to the first switching element and a second current source connected to the second switching element, either of the first and second switching elements being rendered conductive according to the value of the corresponding comparison signal, and that the capacitor is connected to the node where the first and second switching elements are connected and can be charged by one of the current sources and discharged by the other current source.

Further, in alternative, to achieve the above object the invention provides also digital to analog converting means as defined above and which is characterized in that said operation means (14) generates one digital comparison signal, in that said analog to digital converting means (36) is connected to said capacitor (30) via a Darlington pair of transistors, in that the current generating means is connected to a power source and has a current source, a switching element and a diode connected to one end to the node where the current source and switching element are connected, the switching element being rendered conductive according to the value of the comparison signal, and that the capacitor is connected to the other end of said diode and charged by the current source, and discharged by said Darlington pair of transistors.

This invention can be more fully understood from the following detailed description when taken in conjunction with the accompanying drawings, in which:

Fig. 1 is a block circuit diagram of a first embodiment of a digital to analog converting apparatus according to the invention;

Fig. 2 is a flow chart illustration how the apparatus of Fig. 1 operates;

Fig. 3 shows an output voltage waveform;

Fig. 4 is a block circuit diagram of a second embodiment of a digital to analog converting apparatus according to the invention; and

Fig. 5 is a flow chart illustrating how the apparatus of Fig. 4 operates.

Now referring to the accompanying drawings, the embodiments of the invention will be described.

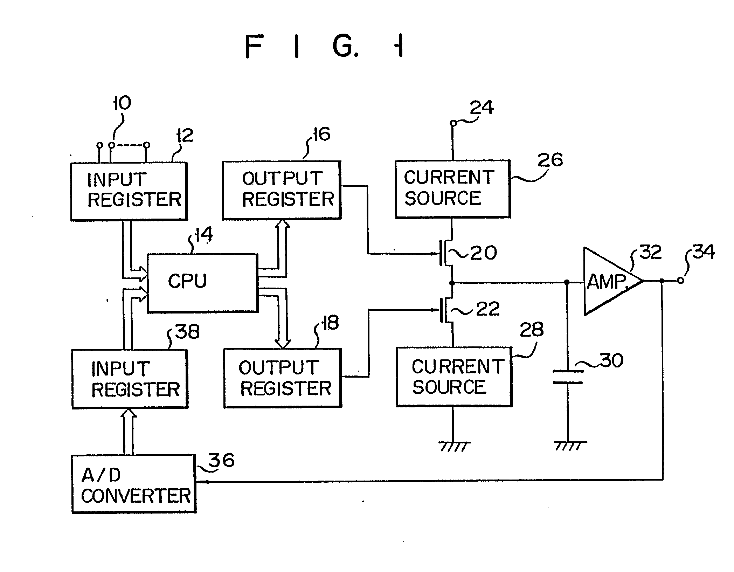

Fig. 1 shows a first embodiment of this invention. An input terminal 10 is connected to an input register 12. An output signal of the input register 12 is supplied to a central processing unit 14 (hereinafter called "CPU 14"). An output signal of the CPU 14 is coupled to two output registers 16 and 18. An output signal of the output register 16 is coupled to a gate of an N channel MOS FET 20, and an output signal of the output register 18 to a gate of an N channel MOS FET 22. Both MOS FETs 20 and 22 function as an analog switch. A power source terminal 24 of positive polarity is grounded via a current source 26, MOS FETs 20 and 22 and another current source 28. The current sources 26 and 28 are each constituted by, for example, a resistor. The current source 26 supplies current to the MOS FET 20, and the current source 28 receives current from the MOS FET 22. The node where the MOS FETs 20 and 22 are connected is grounded via a capacitor 30 and is connected to a voltage follower amplifier 32 of a high input impedance. The output terminal of the amplifier 32 is connected to an output terminal 34 and also to an A/D converter 36. An output signal of the A/D converter 36 is supplied to an input register 38, an output signal of which is supplied to the CPU 14.

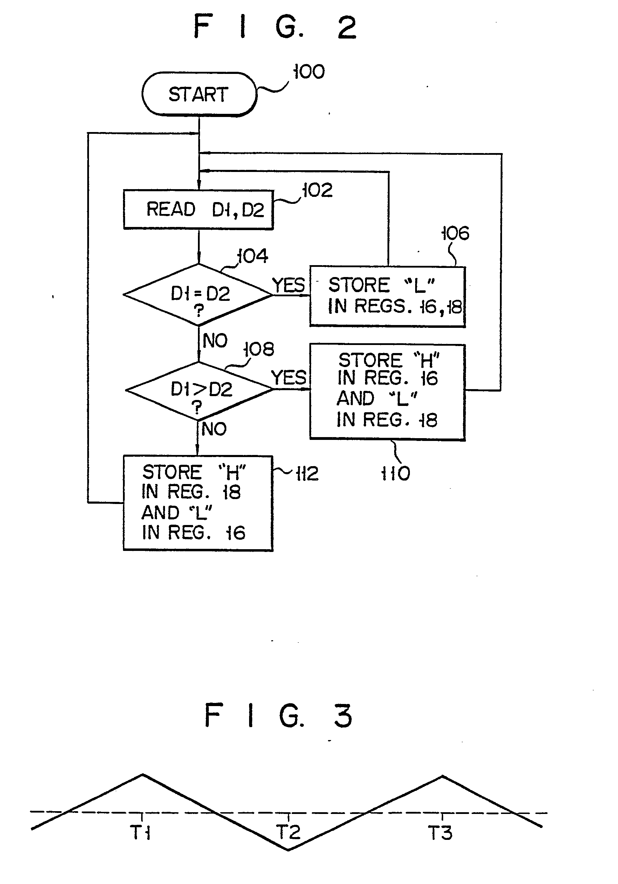

Now referring to Fig. 2 of a flow chart, it will be described how the above-mentioned embodiment of Fig. 1 operates.

Suppose a digital value D1 has been stored into the input register 12 through the input terminal 10 and that the capacitor 30 is charged to a certain voltage. Then, the A/D converter 36 supplies the input register 38 with a digital voltage D2 which corresponds to the output of the amplifier 32, i.e. the output voltage of the capacitor 30 amplified.

In a step 100, the CPU 14 is started. In a step 102 it reads the data D1 and D2 from the input registers 12 and 38, respectively. In a step 104 it determines if D1 and D2 are equal. If D1 and D2, i.e. the digital input value and analog output value, are found equal, the CPU 14 proceeds to a step 106, wherein an L signal is stored into both the output registers 16 and 18. If D1 and D2 are not found equal, the CPU 14 further judges in a step 108 whether D1 is greater than D2 or not. As long as the L signal is stored in both the output registers 16 and 18, the MOS FETs 20 and 22 remain non-conductive and the output voltage of capacitor 30 remains unchanged.

If D1 is found greater than D2 in the step 108, that is, if the digital input value supplied to the input register 12 is greater than the analog output value supplied to the output terminal 34, the CPU 14 proceeds to a step 110. In the step 110 an H signal is stored into the output register 16, and an L signal into the output register 18. In this case, the MOS FET 20 becomes conductive, and the MOS FET 22 becomes non-conductive. As a result, an output current flows from the current source 26 via the MOS FET 20 and the capacitor 30 is therefore charged. The output voltage of the capacitor 30 then rises and is supplied to the A/D converter 36. Consequently, D2 grows, and the analog output value approaches the digital input value.

If D1 is found less than D2 in the step 108, H and L signals are stored in a step 112 respectively into the output registers 18 and 16. In this case, the MOS FET 20 becomes non-conductive, and the MOS FET 22 becomes conductive. As a result, the capacitor 30 is discharged and current flows via the MOS FET 22 to the current source 28. Consequently, the output voltage of the capacitor 30 lowers and D2 becomes smaller and thus approaches D1.

After the steps 106, 110 and 112 are executed, the CPU 14 proceeds again to the step 102 and reads data D1 and D2 from the input registers 12 and 38, respectively. Thereafter, the steps 104, 106, 108, 110 and 112 are repeated once or more times until the analog value supplied to the output terminal 34 becomes equal to the digital input value supplied to the input terminal 10.

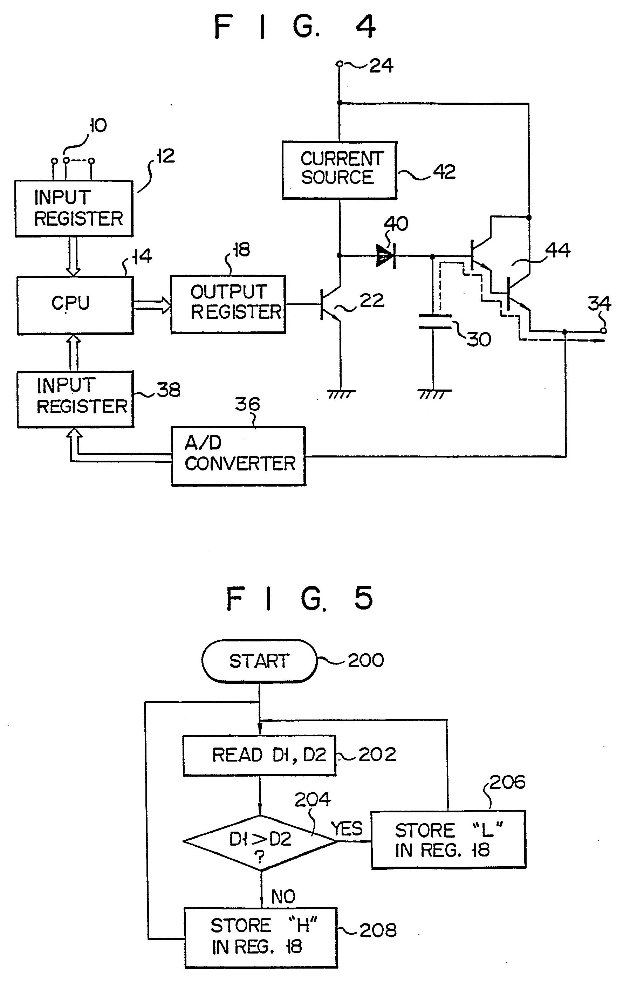

The A/D converter 36 converts the analog output value to a digital value during every sampling period. The output voltage of the A/D converter 36 may therefore fluctuate from the true value as illustrated in Fig. 3, wherein the broken line is the true value and T1, T2 and T3 are sampling time. This does not matter at all. The fluctuation would be 10 mA at most when both the current sources 26 and 28 supply 0.1 mA, the capacitor 30 has a capacitance of 50 µF and the sampling cycle is 5 ms.

As mentioned above, the apparatus of Fig. 1 uses a capacitor instead of a resistor ladder circuit. It is therefore a digital to analog converting apparatus which is small, simple and inexpensive. The CPU 14 may be used not only to achieve analog to digital conversion but also to perform other operations. If the CPU 14 is used in this way, interruption will be effected upon completion of the analog to digital conversion, thereby the operations shown in Fig. 2 are carried out. Once the CPU 14 has stored signals into the output registers 16 and 18, it remains waiting for next interruption. Other devices than the CPU 14 may be used to compare the digital input with the analog output. For example, a discrete comparator or a logic circuit may be used for the purpose. Further, the CPU 14, A/D converter 36 and registers 12 and 38 may be replaced by a microcomputer. Still further, instead of the MOS FETs, bipolar transistors, relay switches, etc. may be used for the analog switches.

Fig. 4 shows a second embodiment of this invention. In Fig. 4, same numerals are used to denote the same elements as shown in Fig. 1. This embodiment is identical with the embodiment of Fig. 1, except that it is not provided with the output register 16 and analog switch 20. As shown in Fig. 4, an output terminal of an output register 18 is connected to a base of an NPN transistor 22. The transistor 22 functions as an analog switch, and its emitter is grounded and its collector is connected to an anode of a diode 40. A power source terminal 24 is connected to an input terminal of a current source 42. The current source 42 supplies current to the transistor 22. A cathode of the diode 40 is grounded via a capacitor 30 and connected to an output terminal 34 via a Darlington pair of transistors 44. The output terminal of the Darlington pair of transistors 44 is connected also to an A/D converter 36.

Now, referring to Fig. 5 of a flow chart, it will be described how the embodiment of Fig. 4 operates when the input registers 12 and 38 receive data D1 and D2, respectively.

In a step 202 the CPU 14 reads D1 and D2 respectively from the input registers 12 and 38. In a step 204 it is judged if D1 is greater than D2. If D1 is found greater than D2, that is, if the digital input value is greater than the analog output value, the CPU 14 proceeds to a step 206, wherein an L signal is stored into the output register 18. In this case, the transistor 22 is non-conductive. As a result, the output current of the current source 42 flows into the capacitor 30 via the diode 40, thus raising the output voltage of the capacitor 30. Consequently, the analog output value approaches the digital input value.

If D1 is found less than D2, that is, if the digital input value is smaller than the analog output value, an H signal is stored into the output register 18 in a step 208. In this case, the transistor 22 become conductive. The output current of the current source 42 flows to the ground via the transistor 22. The capacitor 30 is not therefore charged. As a result, a discharge current path is formed, which extends from the capacitor 30 to the output terminal 34 via Darlington pair of transistors 44 as indicated by a broken line in Fig. 4. The capacitor 30 is thus discharged, whereby the output voltage of the capacitor 30 gradually lowers. Consequently, the analog output value approaches the digital input value.

The steps 202, 204 and 206 are repeated in sequence, once or more times, until the analog output value increases to be equal to the digital input value. Similarly, the steps 202, 204 and 208 are repeated in sequence, once or more times, until the analog output value decreases to be equal to the digital input value. Thus, an analog voltage corresponding to the digital input value will at last be obtained at the output terminal 34.

The embodiment of Fig. 4 uses a Darlington pair of transistors in place of such a current source as used in the embodiment of Fig. 1 to discharge the capacitor 30. A leak current of the Darlington pair of transistors is used to discharge the capacitor 30. This technique renders the apparatus of Fig. 4 simpler than that of Fig. 1.

**Claims**

1. A digital to analog converting apparatus comprising digital to analog converting means having first and second input terminals (12, 38) and generating an analog signal corresponding to a digital signal supplied to the first input terminal (12) and an analog to digital converting means (36) connected to said digital to analog converting means and supplying the second input terminal (38) with a digital signal corresponding to the analog signal generated by said digital to analog converting means, said digital to analog converting means comprising operation means (14) having the first and second input terminals (12, 38) and generating comparison signals representing a difference between two signals supplied to the first and second input terminals (12, 38), said first input terminal (12) being connected to receive a digital signal, current generating means (26, 28) connected to said operation means (14) for generating current according to the value of the comparison signal, and a capacitor (30), connected to said current generating means (26, 28), said analog to digital converting means (36) being connected to said capacitor (30) and the second input terminal (38) of said operation means (14) and converting the output voltage of said capacitor (30) to a digital signal,
characterized in that said operation means (14) generates two digital comparison signals, in that said current generating means (26, 28) is connected to a power source and has a first current source (26), a first switching element (20) connected to the first current source (26), a second switching element (22) connected to said first switching element (22) and a second current source (28) connected to said second switching element (22), either of said first and second switching elements (20, 22) being rendered conductive according to the value of the corresponding comparison signal and that said capacitor (30) is connected to the node where said first and second switching elements (20, 22) are connected and can be charged by one of said current sources (26, 28) and can be discharged by the other current source (Fig. 1).

2. A digital to analog converting apparatus comprising digital to analog converting means having first and second input terminals (12, 38) and generating an analog signal corresponding to a digital signal supplied to the first input terminal (12) and an analog to digital converting means (36) connected to said digital to analog converting means and supplying the second input terminal (38) with a digital signal corresponding to the analog signal generated by said digital to analog converting means, said digital to analog converting means comprising operation means (14) having the first and second input terminals (12, 38) and generating comparison signals representing a difference between two signals supplied to the first and second input terminals (12, 38), said first input terminal (12) being connected to receive a digital signal, current generating means (42) connected to said operation means (14) for generating current according to the value of the comparison signal, and a capacitor (30) connected to said current generating means (42), said analog to digital converting means (36) being connected to said capacitor (30) and the second input terminal (38) of said operation means (14) and converting the output voltage of said capacitor (30) to a digital signal, characterized in that said operation means (14) generates only one digital comparison signal, in that said analog to digital converting means (36) is connected to said capacitor (30) via a Darlington pair of transistors (44), in that said current generating means is connected to a power source and has a current source (42) a switching element (22) and a diode (40) connected at one end to the node where said current source (42) and switching element (22) are connected, said switching element (22) being rendered conductive according to the value of the comparison signal, and that said capacitor (30) is connected to the other end of said diode (40) and charged by said current source (42), and discharged by said Darlington pair of transistors (Fig. 4).

**Revendications**

1. Appareil de conversion numérique-analogique comprenant un moyen de conversion numérique-analogique qui possède une première et une deuxième borne d'entrée (12, 38) et qui produit un signal analogique correspondant à un signal numérique délivré à la première borne d'entrée (12) et un moyen de conversion analogique-numérique (36) connecté audit moyen de conversion numérique-analogique et délivrant à la deuxième borne d'entrée (38) un signal numérique qui correspond au signal analogique produit par ledit moyen de conversion numérique-analogique, ledit moyen de conversion numérique-analogique comprenant un moyen d'opération (14) qui possède la première et la deuxième borne d'entrée (12, 38) et qui produit des signaux de comparaison représentant la différence entre deux signaux délivrés à la première et à la deuxième borne d'entrée (12, 38), la première borne d'entrée (12) étant connectée de façon à recevoir un signal numérique, un moyen générateur de courant (26, 28) connecté au moyen d'opération (14) afin de produire un courant en fonction de la valeur du signal de comparaison, et un condensateur (30) connecté au moyen générateur de courant (26, 28), le moyen de conversion analogique-numérique (36) étant connecté au condensateur (30) et à la deuxième borne d'entrée (38) dudit moyen d'opération (14) et transformant le signal de sortie du condensateur (30) en un signal numérique, caractérisé en ce que ledit moyen d'opération (14) produit deux signaux de comparaison numériques, en ce que le moyen générateur de courant ton (figure 4).

(26, 28) est connecté à une source d'alimentation électrique et possède une première source de courant (26), un premier élément de commutation (20) connecté à la première source de courant (26), un deuxième élément de commutation (22) connecté au premier élément de commutation (22) et une deuxième source de courant (28) connectée au deuxième élément de commutation (22), le premier ou le deuxième élément de commutation (20, 22) étant rendu conducteur en fonction de la valeur du signal de comparaison correspondant, et en ce que le condensateur (30) est connecté au noeud de connexion du premier et du deuxième élément de commutation (20, 22) et peut être chargé par l'une desdites sources de courant (26, 28) et être déchargé par l'autre source de courant (figure 1).

2. Appareil de conversion numérique-analogique, comprenant un moyen de conversion numérique-analogique qui possède une première et une deuxième borne d'entrée (12, 38) et qui produit un signal analogique correspondant à un signal numérique délivré à la première borne d'entrée (12) et un moyen de conversion analogique-numérique (36) connecté au moyen de conversion numérique-analogique et délivrant à la deuxième borne d'entrée (38) un signal numérique correspondant au signal analogique produit par ledit moyen de conversion numérique-analogique, ledit moyen de conversion numérique-analogique comprenant un moyen d'opération (14) qui possède la première et la deuxième borne d'entrée (12, 38) et qui produit des signaux de comparaison représentant la différence entre deux signaux délivrés à la première et à la deuxième borne d'entrée (12, 38), la première borne d'entrée (12) étant connectée de façon à recevoir un signal numérique, un moyen générateur de courant (42) connecté audit moyen d'opération (14) afin de produire un courant en fonction de la valeur du signal de comparaison, et un condensateur (30) connecté au moyen générateur de courant (42), le moyen de conversion analogique-numérique (36) étant connecté au condensateur (30) et à la deuxième borne d'entrée (38) dudit moyen d'opération (14) et transformant le tension de sortie du condensateur (30) en un signal numérique, caractérisé en ce que ledit moyen d'opération (14) produit un seul signal de comparaison numérique, en ce que le moyen de conversion analogique-numérique (36) est connecté au condensateur (30) via une paire de transistors Darlington (44), en ce que le moyen générateur de courant est connecté à une source d'alimentation électrique et possède une source de courant (42), un élément de commutation (22) et une diode (40) connectée par l'une de ses extrémités au noeud de connexion de la source de courant (42) et de l'élément de commutation (22), ledit élément de commutation (22) étant rendu conducteur en fonction de la valeur du signal de comparaison, et en ce que le condensateur (30) est connecté à l'autre extrémité de la diode (40) et est chargé par ladite source de courant (42) et déchargé par ladite paire de transistors Darling-

**Patentansprüche**

1. Digital-Analog-Wandler, umfassend eine Digital-Analog-Wandlereinheit mit ersten und zweiten Eingangsklemmen (12, 38) und zum Erzeugen eines Analogsignals entsprechend einem der ersten Eingangsklemme (12) zugeführten Digitalsignal und eine mit der Digital-Analog-Wandlereinheit verbundene Analog-Digital-Wandlereinheit (36) zur Beschickung der zweiten Eingangsklemme (38) mit einem Digitalsignal entsprechend dem von der Digital-Analog-Wandlereinheit erzeugten Analogsignal, wobei die Digital-Analog-Wandlereinheit eine die ersten und zweiten Eingangsklemmen (12, 38) enthaltende Operationseinheit (14) aufweist, die Vergleichssignale, welche eine Differenz zwischen zwei den ersten und zweiten Eingangsklemmen (12, 38) zugeführten Signalen angeben, erzeugt, und wobei die erste Eingangsklemme (12) zur Abnahme eines Digitalsignals geschaltet ist, eine mit der Operationseinheit (14) verbundene Stromerzeugungseinrichtung (26, 28) zum Erzeugen von Strom entsprechend der Größe des Vergleichssignals und einen an die Stromerzeugungseinrichtung (26, 28) angeschlossenen Kondensator (30), wobei die Analog-Digital-Wandlereinheit (36) mit dem Kondensator (30) und der zweiten Eingangsklemme (38) der Operationseinheit (14) verbunden ist und die Ausgangsspannung des Kondensators (30) in ein Digitalsignal umwandelt,

dadurch gekennzeichnet, daß die Operationseinheit (14) zwei digitale Vergleichssignale erzeugt, daß die Stromerzeugungseinrichtung (26, 28) zwischen Energiequellen geschaltet ist und eine erste Stromquelle (26), ein mit der ersten Stromquelle (26) verbundenes erstes Schalterelement (20), ein mit dem ersten Schalterelement (20) verbundenes zweites Schalterelement (22) und eine an das zweite Schalterelement (22) angeschlossene zweite Stromquelle (28) aufweist, wobei jedes der ersten und zweiten Schalterelemente (20, 22) nach Maßgabe der Größe des betreffenden Vergleichssignals durchschaltbar ist, und daß der Kondensator (30) an den Knotenpunkt, an dem erstes und zweites Schalterelement (20, 22) verbunden sind, angeschlossen und durch die eine Stromquelle (26, 28) aufladbar und durch die andere Stromquelle entladbar ist (Fig. 1).

2. Digital-Analog-Wandler, umfassend eine Digital-Analog-Wandlereinheit mit ersten und zweiten Eingangsklemmen (12, 38) und zum Erzeugen eines Analogsignals entsprechend einem der ersten Eingangsklemme (12) zugeführten Digitalsignal und eine mit der Digital-Analog-Wandlereinheit verbundene Analog-Digital-Wandlereinheit (36) zur Beschickung der zweiten Eingangsklemme (38) mit einem Digitalsignal entsprechend dem von der Digital-Analog-Wandlereinheit erzeugten Analogsignal, wobei die Digital-Analog-Wandlereinheit eine die ersten und zweiten Eingangsklemmen (12, 38) enthaltende Operationseinheit (14) aufweist, die Vergleichssignale, welche eine Differenz zwischen zwei den ersten und zweiten Eingangsklemmen (12, 38) zugeführten Signalen angeben, erzeugt, und wobei die erste Eingangsklemme (12) zur Abnahme eines Digitalsignals geschaltet ist, eine mit der Operationseinheit (14) verbundene Stromerzeugungseinrichtung (42) zum Erzeugen von Strom entsprechend der Größe des Vergleichssignal und einen an die Stromerzeugungseinrichtung (42) angeschlossenen Kondensator (30), wobei die Analog-Digital-Wandlereinheit (36) mit dem Kondensator (30) und der zweiten Eingangsklemme (38) der Operationseinheit (14) verbunden ist und die Ausgangsspannung des Kondensators (30) in ein Digitalsignal umwandelt,

dadurch gekennzeichnet, daß die Operationseinheit (14) nur ein einziges digitales Vergleichssignal erzeugt, daß die Analog-Digital-Wandlereinheit (36) über ein Darlington-Transistorpaar (44) an den Kondensator (30) angeschlossen ist, daß die Stromerzeugungseinrichtung zwischen Energiequellen geschaltet ist und eine Stromquelle (42), ein Schalterelement (22) und eine Diode (40) aufweist, die an der einen Seite an den Knotenpunkt, an dem die Stromquelle (42) und das Schalterelement (22) verbunden sind, angeschlossen ist, wobei das Schalterelement (22) nach Maßgabe der Größe des Vergleichssignals durchschaltbar ist, und daß der Kondensator (30) an die andere Seite der Diode (40) angeschlossen und durch die Stromquelle (42) aufladbar und durch das Darlington-Transistorpaar entladbar ist (Fig. 4).

F I G. 1

0 052 226

# F I G. 2

```
        ┌─────────┐
        │  START  │ ─── 100
        └─────────┘
             │
             ▼
      ┌──────────────┐
      │  READ  D1,D2 │ ─── 102
      └──────────────┘
             │
             ▼        104
          ◇─────────◇        YES    ┌──────────────────┐  ─── 106
          │ D1 = D2 │ ───────────── │  STORE "L"       │
          │    ?    │               │  IN REGS. 16,18  │
          ◇─────────◇               └──────────────────┘
             │ NO
             ▼        108
          ◇─────────◇        YES    ┌──────────────────┐
          │ D1 > D2 │ ───────────── │  STORE "H"       │
          │    ?    │               │  IN REG. 16      │
          ◇─────────◇               │  AND "L"         │
             │ NO                    │  IN REG. 18      │
             ▼                       └──────────────────┘
      ┌──────────────┐ ─── 112              110
      │  STORE  "H"  │
      │  IN REG. 18  │
      │  AND "L"     │
      │  IN REG. 16  │
      └──────────────┘
```

# F I G. 3

T1    T2    T3

# F I G. 4

# F I G. 5

3